(19) **Europäisches Patentamt European Patent Office Office européen des brevets**

(11) **EP 1 341 718 B1**

(12) **FASCICULE DE BREVET EUROPEEN**

(45) Date de publication et mention de la délivrance du brevet:
**23.07.2008 Bulletin 2008/30**

(51) Int Cl.:
*C01B 31/02* (2006.01)        *C23C 16/26* (2006.01)
*H05H 1/24* (2006.01)        *C01B 3/00* (2006.01)

(21) Numéro de dépôt: **01982567.8**

(22) Date de dépôt: **26.10.2001**

(86) Numéro de dépôt international:
**PCT/FR2001/003334**

(87) Numéro de publication internationale:
**WO 2002/034669 (02.05.2002 Gazette 2002/18)**

(54) **PROCEDE ET DISPOSITIF DE DEPOT PAR PLASMA A LA RESONANCE CYCLOTRON ELECTRONIQUE DE NANOTUBES DE CARBONE MONOPAROIS ET NANOTUBES AINSI OBTENUS**

VERFAHREN UND VORRICHTUNG ZUM ECR PLASMA AUFBRINGEN VON EINWANDIGEN KOHLENSTOFFNANORÖHREN SOWIE ERHALTENE NANORÖHREN

METHOD AND DEVICE FOR ELECTRONIC CYCLOTRON RESONANCE PLASMA DEPOSIT OF SINGLE-WALL CARBON NANOTUBES AND RESULTING NANOTUBES

(84) Etats contractants désignés:
**AT BE CH CY DE DK ES FI FR GB GR IE IT LI LU MC NL PT SE TR**

(30) Priorité: **27.10.2000 FR 0013831**

(43) Date de publication de la demande:
**10.09.2003 Bulletin 2003/37**

(73) Titulaire: **COMMISSARIAT A L'ENERGIE ATOMIQUE**
**75015 Paris (FR)**

(72) Inventeurs:
• **DELAUNAY, Marc**
**F-38240 MEYLAN (FR)**
• **VANNUFFEL, Cyril**
**F-38100 GRENOBLE (FR)**

(74) Mandataire: **Poulin, Gérard et al**
**Société BREVATOME**
**3, rue du Docteur Lancereaux**
**75008 Paris (FR)**

(56) Documents cités:
**EP-A- 0 967 844          WO-A-01/03158**

• **DATABASE INSPEC [en ligne] INSTITUTE OF ELECTRICAL ENGINEERS, STEVENAGE, GB; HOSHI F ET AL: "Field emission and structure of aligned carbon nanofibers deposited by ECR-CVD plasma method" Database accession no. 6896573 XP002171730 & 3RD SPECIALIST MEETING ON AMORPHOUS CARBON (SMAC 2000), MONDOVI, ITALY, 30 AUG.-1 SEPT. 2000, vol. 10, no. 2, pages 254-259, Diamond and Related Materials, Feb. 2001, Elsevier, Switzerland ISSN: 0925-9635**
• **SUNG S L ET AL: "WELL-ALIGNED CARBON NITRIDE NANOTUBES SYNTHESIZED IN ANODIC ALUMINA BY ELECTRON CYCLOTRON RESONANCE CHEMICAL VAPOR DEPOSITION" APPLIED PHYSICS LETTERS,US,AMERICAN INSTITUTE OF PHYSICS. NEW YORK, vol. 74, no. 2, 11 janvier 1999 (1999-01-11), pages 197-199, XP000804860 ISSN: 0003-6951**
• **TSAI S H ET AL: "Synthesis and characterization of the aligned hydrogenated amorphous carbon nanotubes by electron cyclotron resonance excitation" THIN SOLID FILMS,CH,ELSEVIER-SEQUOIA S.A. LAUSANNE, vol. 366, no. 1-2, mai 2000 (2000-05), pages 11-15, XP004203828 ISSN: 0040-6090**

## Description

La présente invention concerne un procédé de dépôt par plasma à la résonance cyclotron électronique de nanotubes de carbone monoparois.

L'invention concerne, en outre, les nanotubes monoparois ainsi obtenus.

Le domaine technique de la demande peut être défini, de manière générale, comme celui du dépôt de couches de carbone sur un substrat.

On s'intéresse, plus précisément, dans la présente demande, à la préparation de dépôts ou couches de carbone formés de nanotubes ou de nanofibres et, en particulier, à la préparation de nanotubes de carbone monoparois (Single-Wall-NanoTubes ou SWNT, en anglais).

En effet, les nanotubes de carbone peuvent être classés en deux grandes catégories ; il s'agit, d'une part, des nanotubes multiparois et, d'autre part, des nanotubes monoparois. Ces deux catégories de nanotubes forment deux types de matériaux bien distincts, aussi bien en structure qu'en synthèse.

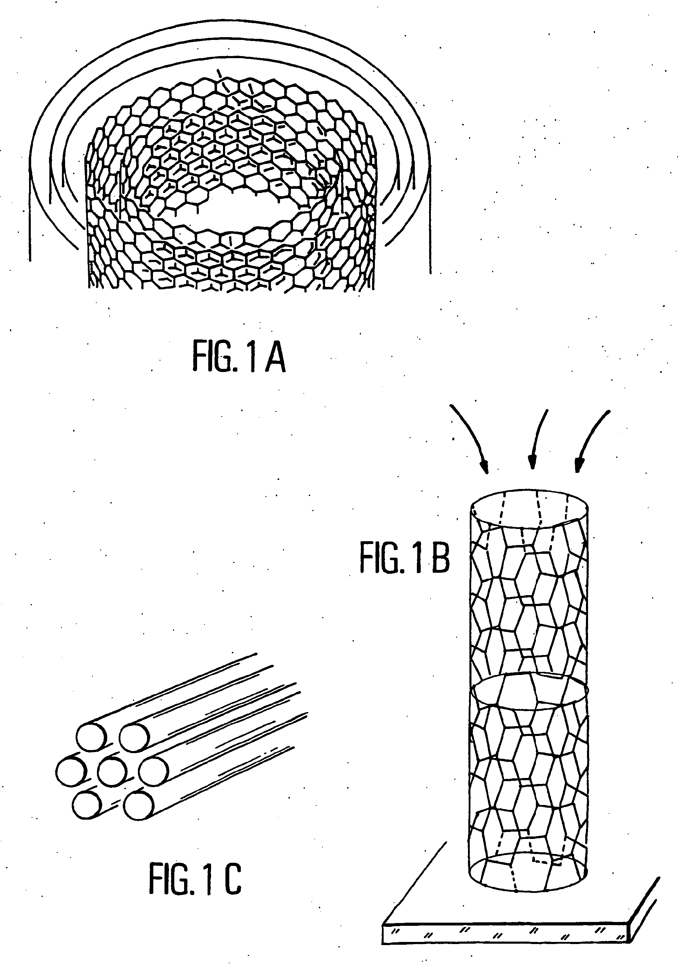

On a représenté sur la figure 1A un exemple de nanotube de carbone multiparoi, qui comprend plusieurs tubes concentriques les uns dans les autres, le premier tube a un diamètre de 7 à 10 nm et le diamètre total du nanotube multiparoi, qui peut compter de 2 à plusieurs dizaines de tubes, peut varier de 4 à plusieurs dizaines de nm, par exemple 30 nm.

Sur la figure 1B, est représenté un nanotube de carbone monoparoi sur un substrat.

Les nanotubes de carbone monoparois (SWNTs) ont un diamètre d'environ 1 nm et sont souvent regroupés en faisceau ou fagots (« Bundles », en anglais).

Depuis la découverte des nanotubes de carbone par S. IJIMA, en 1991, des efforts importants de synthèse de nanotubes de carbone, en particulier monoparois, ont été effectués en vue de nombreuses applications, comme la nanoélectronique, avec les réseaux de nanoconducteurs [1], le stockage de l'hydrogène pour les piles à combustible [2], les émetteurs d'électrons par les écrans plats [3], ou d'autres applications dans lesquelles on met à profit les excellentes propriétés mécaniques des nanotubes et le fait qu'ils peuvent être aussi bien métalliques, que semi-conducteurs.

En effet, à mi-chemin entre les microarchitectures actuelles, telles que la microélectronique du silicium et les polymères, et les molécules organiques et chaînes de carbone de la biologie, les architectures développées à partir de plans de graphène, comme les nanotubes et les fullerènes, etc., présentent de nombreuses possibilités de construction de nanosystèmes. L'exemple le plus prometteur est la réalisation de réseaux de type neuronal [1] et le greffage de molécules organiques et biologiques.

Par rapport aux nanotubes de carbone multiparois, les nanotubes monoparois présentent l'avantage, en microélectronique, d'être mieux définis pour obtenir les mêmes propriétés.

Des nanotubes monoparois de haute qualité sont nécessaires pour les applications aussi bien fondamentales que technologiques ; par nanotubes de haute qualité, on entend des nanotubes exempts de défauts chimiques, structuraux et d'impuretés, telles que des cristaux graphitiques ou des phases amorphes sur une longueur significative le long de l'axe d'un tube.

Dans le tableau I, situé à la fin de la description, sont présentés différents dispositifs et procédés de dépôts de nanotubes de carbone monoparois.

Les principaux procédés permettent de fabriquer des nanotubes de carbone monoparois utilisent l'arc électrique et l'ablation laser avec du graphite, avec des catalyseurs de types Fe, Co, Ni, Rh et Pt.

Ainsi, le document [2] décrit la préparation de nanotubes de carbone monoparois par synthèse avec une décharge à l'arc à hydrogène sur un substrat pourvu d'un catalyseur formé de poudres de Ni, Co et Fe, et de $Fe_2S$, en tant qu'amorceur de croissance. Les nanotubes préparés se présentent sous la forme de faisceaux enchevêtrés d'environ 20 nm de diamètre, comprenant environ 40 % de catalyseur.

Le document [5] indique que des nanotubes de carbone monoparois peuvent être produits par évaporation à l'arc dans de l'hélium, en utilisant des mélanges binaires de métaux du groupe du platine, comme catalyseur. Le rendement de production des SWNTs est remarquablement amélioré lorsqu'on se sert d'un catalyseur Rh-Pt, non magnétique.

Le document [6] mentionne que les nanotubes de carbone monoparois peuvent être produits avec un rendement plus élevé que par décharge à l'arc, en réalisant l'évaporation laser d'une tige de graphite, et améliore cette technique en fabriquant des nanotubes de carbone monoparois avec des rendements supérieurs à 70 % par condensation d'un mélange de carbone-nickel-cobalt évaporé au laser à 1 200°C. Les « SWNTs » obtenus ont un diamètre uniforme, voisin de 1,4 nm environ et ils s'organisent en cordes « ropes » ou faisceaux de 100 à 500 « SWNTs » dans un réseau bidimensionnel triangulaire.

Enfin, le document [4] montre que la technique de l'arc électrique, utilisée, de préférence, pour générer des fullerènes et des nanotubes multiparois et qui est moins coûteuse et plus facile à mettre en oeuvre, mais qui conduit à de faibles rendements en nanotubes de carbone monoparois, peut donner de grandes quantités de « SWNTs » dont les caractéristiques sont similaires à celles des nanotubes obtenus par ablation laser. Ce document utilise un catalyseur Ni-Co contenant, en outre, et, de préférence, de l'yttrium, qui conduit à la formation de structures semblables à des filaments enchevêtrés où à des faisceaux comprenant environ 20 nanotubes, ainsi qu'à des nanoparticules sphériques de catalyseur de 3 à 20 nm de diamètre.

Les procédés de décharge à l'arc électrique et d'ablation laser présentent toutefois de nombreux inconvénient.

En effet, ces deux procédés impliquent l'évaporation d'atomes de carbone à partir de sources de carbone solides à des températures très élevées, ce qui impose une limite à la quantité de nanotubes qui peuvent être synthétisés, en outre, ces procédés d'évaporation font croître ces nanotubes sous une forme hautement enchevêtrée avec la formation d'espèces parasites de carbone ou de métal. Les nanotubes de carbone monoparois sont difficiles à purifier (suie), et à manipuler, en particulier, il n'est pas aisé de les recueillir sur les électrodes en graphite. Enfin, ces nanotubes ne peuvent être facilement assemblés pour construire l'architecture des dispositifs à nanotubes.

Par ailleurs, on sait que le dépôt chimique en phase vapeur (CVD) d'hydrocarbures sur des catalyseurs métalliques est un procédé classique pour produire des matériaux carbonés. Diverses formes de fibres de carbone, de filaments et de nanotubes multiparois ont été synthétisés par CVD.

En ce qui concerne le dépôt de nanotubes de carbone monoparois, le document [1] décrit la synthèse par CVD de méthane, de nanotubes de carbone monoparois sur des plaquettes de silicium, présentant des motifs catalytiques sous la forme d'îlots de Fe, Mo, de taille micrométrique.

Le procédé consiste à chauffer le substrat à motifs dans un four à une température de 1 000°C sous une atmosphère d'argon, puis à remplacer l'argon par du méthane maintenu pendant 10 minutes à la même température. Les nanotubes préparés sont des nanotubes monoparois, individuels, avec des diamètres de 1 à 3 nm et des longueurs de quelques dizaines de $\mu$m.

Le document [8] décrit un procédé de préparation de « SWNTs » par catalyse en phase gazeuse, dans lequel les catalyseurs se forment in-situ, par décomposition thermique de fer pentacarbonyle dans un courant chauffé à de 800 à 1 200°C de monoxyde de carbone. On obtient ainsi des nanotubes de carbone monoparoi d'un diamètre de limite inférieure ou égale à 0,7 nm et, en moyenne, de l'ordre de 1,2 nm.

Le document [7] est relatif à la synthèse de nanotubes de carbone monoparois par CVD, utilisant le méthane comme charge carbonée à environ 900°C, sur des substrats pourvus d'un motif de catalyseur. On obtient ainsi, avec un fort rendement, des nanotubes monoparois sous la forme de tubes individuels ou de faisceaux. Les meilleurs résultats sont obtenus avec des catalyseurs bimétalliques Fe/Mo sur un support silice-alumine.

Tous les procédés CVD, décrits ci-dessus, ont l'avantage de déposer les nanotubes de carbone monoparois directement sur les substrats, mais ils sont effectués à une haute température, généralement voisine de 800-1 200°C, qui est donc incompatible avec de nombreux substrats, comme ceux du type verre. En outre, les dépôts comportent obligatoirement des îlots de catalyseur, comme par les procédés par arc ou ablation laser.

D'autres procédés (CVD), mettant en oeuvre des filaments et des micro-ondes avec du méthane dilué dans de l'hydrogène à plusieurs dizaines de millibars, ne permettent de préparer que des nanotubes multiparois.

Les sources de plasma à la résonance cyclotron électronique à fort confinement magnétique permettent de générer des plasmas à faible pression avec des électrons énergétiques. Il est ainsi possible de dissocier fortement des molécules organiques, par exemple, de méthane ou d'acétylène, pour réaliser des dépôts, notamment des dépôts graphitiques.

Ainsi, le document [9] décrit le dépôt par plasma à la résonance cyclotron électronique de films de type DLC (« Diamond Like Carbon ») à partir d'un mélange méthane-hydrogène.

Le document [10] décrit une source à plasma micro-ondes linéaire à courants permanents.

Le document [11] a trait à un procédé de dépôt par plasma à la résonance cyclotron électronique de couches de carbone émetteur d'électrons.

La formation de nanotubes de carbone monoparoi (« SWNTs ») n'a jamais pu être démontrée par les procédés plasma à la résonance cyclotron électronique.

Enfin, aucun des procédés, décrits ci-dessus, n'autorise le dépôt de nanotubes de carbone monoparois sans catalyseur et sur de grandes surfaces, c'est-à-dire généralement supérieures ou égales à 1 $m^2$.

Il existe donc un besoin pour un procédé de dépôt de nanotubes de carbone monoparois, ne nécessitant pas de catalyseur, qui permette le dépôt de ces,nanotubes à une température relativement basse (à savoir, par exemple, d'environ 600 à 700°C) sur de grandes surfaces et sur tous les types de substrats.

Le but de la présente invention est donc de fournir un procédé de dépôt de nanotubes de carbone monoparois, qui réponde, entre autres, à l'ensemble des besoins mentionnés ci-dessus.

Le but de la présente invention est encore de fournir un procédé de dépôt de nanotubes de carbone monoparois, qui ne présente pas les inconvénients, défauts, limitations et désavantages des procédés de l'art antérieur et qui résolve les problèmes de l'art antérieur.

Le but, et d'autres encore, sont atteints, conformément à la présente invention, par un procédé de dépôt par plasma à la résonance cyclotron électronique de nanotubes de carbone monoparois, sur un substrat exempt de catalyseur, par injection d'une puissance micro-ondes dans une chambre de dépôt comprenant une structure magnétique de confinement à miroir magnétique, et au moins une zone de résonance cyclotron électronique à l'intérieur même ou en bordure, de ladite chambre de dépôt et faisant face audit substrat, moyennant quoi, on provoque, sous une pression inférieure à $10^{-3}$ mbar, la dissociation et/ou l'ionisation d'un gaz contenant du carbone dans ledit miroir magnétique au reste de la chambre de dépôt, en produisant des espèces qui vont se déposer sur ledit substrat qui est chauffé ; procédé dans lequel la surface du substrat présente des reliefs et/ou des creux.

Avantageusement, ces reliefs et/ou ces creux comportent au moins une surface sensiblement perpendiculaire au plan principal de la surface du substrat pour obtenir avantageusement une croissance des nanotubes monoparois sensiblement perpendiculaire au plan principal de la surface du substrat.

Il est également possible que les reliefs et/ou les creux aient une forme courbe, curviligne, respectivement concave ou convexe.

De manière plus précise, le procédé de dépôt selon la revendication 1, comprenant les étapes suivantes :

- chauffage du substrat ;
- établissement d'une pression inférieure ou égale à $10^{-3}$ mbar, de gaz contenant du carbone ;
- injection de la puissance micro-ondes, et création du plasma à partir dudit gaz contenant du carboné, pour une valeur du champ magnétique correspondant à la résonance cyclotron électronique ;
- création d'une différence de potentiel entre le plasma et le substrat ;
- dissociation et/ou ionisation des molécules dans ledit miroir magnétique au centre de la chambre de dépôt ;
- dépôt des espèces formées sur ledit substrat pour obtenir des nanotubes de carbone monoparois.

De préférence, ces nanotubes de carbone monoparois sont sensiblement perpendiculaires au plan principal de la surface du substrat.

Dans une forme de réalisation avantageuse du procédé selon l'invention, les étapes sont réalisées simultanément.

Le procédé selon l'invention se situe en fait entre les deux procédés extrêmes, d'une part, de dépôt physique en phase vapeur (PVD) et, d'autre part, de dépôt chimique en phase vapeur (CVD) et constitue un excellent compromis de ces deux techniques, sans en présenter aucun des inconvénients.

Le procédé selon l'invention répond aux besoins mentionnés ci-dessus et résout les problèmes des procédés de l'art antérieur, en particulier, contrairement aux procédés de dépôt de nanotubes monoparois de l'art antérieur, le procédé selon l'invention, qui met en oeuvre un plasma RCE particulier et un substrat spécifique, permet de réaliser des dépôts sur de très grandes surfaces supérieures, par exemple, à 1 m$^2$.

De manière fondamentale, le procédé selon l'invention évite l'utilisation de catalyseurs, ce qui a pour conséquence l'obtention de nanotubes très purs avec un rendement élevé, à partir uniquement de composés organiques.

Dans le procédé de l'invention, on utilise, tout d'abord, une source de plasma RCE particulière, qui est une source confinente, à cause de la mise en oeuvre d'une structure magnétique à miroir magnétique, de préférence déséquilibrée. Le miroir provoque un confinement dans la chambre de dépôt et donc la dissociation du gaz contenant du carbone, tel que le $CH_4$.

D'autre part, la zone de résonance cyclotron électronique RCE, au contraire de la plupart des procédés à plasma RCE, se trouve, selon l'invention, à l'intérieur même de la chambre de dépôt ou en bordure de celle-ci, face au substrat, et est ainsi intégrée à celle-ci ou très proche de celle-ci, il n'y a donc pas de séparation ou quasiment pas entre la chambre de réaction du plasma RCE et la chambre de dépôt.

Ensuite, dans le procédé de l'invention, ladite source de plasma RCE, particulière et confinente, est mise en oeuvre à très basse pression, généralement inférieure à $10^{-3}$ mbar.

C'est essentiellement la combinaison de cette source de plasma RCE particulière et confinante avec cette très basse pression qui permet, selon l'invention, de dissocier fortement les molécules organiques pour obtenir des nanotubes de carbone monoparois ; tandis que le substrat spécifique, profilé, mis en oeuvre permet aux « SWNTs » de croître hors de la surface du substrat, sensiblement perpendiculairement au plan principal de celle-ci, et vers le plasma.

Le plasma RCE créé selon l'invention, est un plasma stationnaire, stable, qui une fois installé, persiste et se stabilise. On obtient une dissociation partielle et complète des molécules allant jusqu'au terme des dissociations possible, par exemple, le méthane pourra se dissocier jusqu'à donner des espèces C°.

Plus précisément, on peut dire que c'est la durée de vie des particules du plasma qui augmente.

Autrement dit, ce confinement magnétique notable permet d'augmenter le temps de vie des ions et des électrons qui restent piégés dans le miroir magnétique au centre de la chambre de dépôt et le long des lignes de champ. Les taux de dissociation et d'ionisation des molécules dans le plasma sont donc ainsi augmentés avec des collisions électroniques du type :

$$CH_4 + e \rightarrow CH_3^+ + H° + e + e$$

$$CH_4 + e \rightarrow CH_3° + H° + e$$

$$CH° + e \rightarrow C° + H° + e,$$

etc.

La faible pression augmente l'énergie des électrons et diminue les recombinaisons.

De manière surprenante, selon l'invention, il a pu être constaté que pour une pression non conforme à l'invention, c'est-à-dire pour une pression supérieure à $10^{-3}$ mbar, il n'y a pratiquement pas de croissance de nanotubes de carbone monoparois, mais, au contraire, l'apparition de grains de graphite ou de diamant de différentes dimensions avec parfois des amas de cristaux graphitiques.

Des nanotubes de carbone monoparois, ayant la structure décrite plus haut et sans catalyseur, n'ont jamais pu être obtenues par les procédés de l'art antérieur.

En outre et selon un avantage essentiel du procédé selon l'invention, les nanotubes de carbone monoparois sont obtenus directement à partir d'un composé organique, sans qu'il soit besoin de recourir à un catalyseur, tel qu'un métal, par exemple, le nickel, le cobalt ou autre.

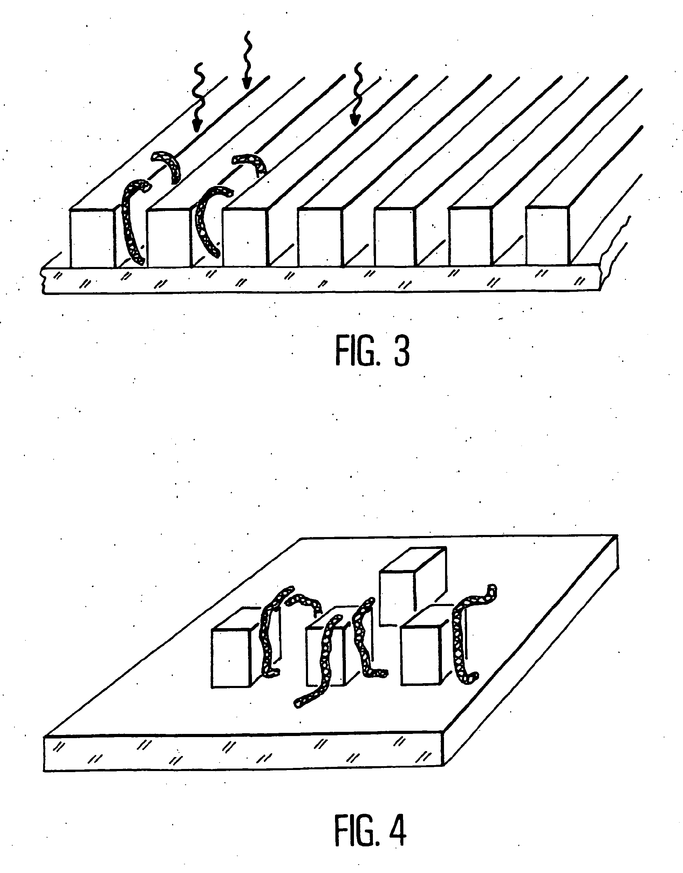

Il s'agit d'une croissance dite en protubérances. Le substrat profilé spécifique, mis en oeuvre dans le procédé selon l'invention, permet de manière surprenante, aux nanotubes de carbone de croître sensiblement perpendiculairement à la surface du substrat. La croissance se déroule donc sans catalyseur - c'est là un des avantages fondamentaux du procédé de l'invention - et préférentiellement sur les pointes et protubérances des tubes, c'est-à-dire que les atomes et les ions carbone du plasma vont se fixer préférentiellement vers les excroissances ou extrémités des tubes et non uniformément sur toute la surface : on obtient ainsi, grâce notamment à la mise en oeuvre d'un substrat dont la surface présente des creux et/ou des reliefs (substrat non-lisse), des nanotubes parfaitement différenciés, non enchevêtrés, d'excellente qualité sur toute leur longueur (voir figures 3 et 4).

La surface du substrat, conformément à l'invention, présente des creux et/ou des reliefs. Cela signifie que la surface du substrat présente, par exemple, des tranchées et/ou rainures, et/ou rayures et/ou gorges et/ou arêtes et/ou cannelures, et/ou trous, et/ou cavités, et/ou plots et/ou pointes et/ou aspérités, et/ou bossages et/ou gaufrages.

Les tranchées, rainures, rayures, arêtes, cannelures, etc. sont généralement linéaires et, de préférence, elles sont parallèles.

Leur profondeur et leur largeur sont généralement de une dizaine de nm à une dizaine de $\mu$m.

Les trous, cavités, etc., ont généralement les dimensions suivantes : 10 nm à 10 $\mu$m.

Le substrat peut être aussi défini comme étant un substrat dont la surface est profilée ou non-lisse, on entend par ces expressions, par exemple, que le substrat comporte au moins un plan qui est sensiblement perpendiculaire au plan principal de la surface du substrat.

La surface du substrat pourvue de creux et/ou de reliefs a cependant a généralement une forme sensiblement plane.

Les plots ou bossages ont généralement la forme de cubes, parallélépipèdes, et les dimensions suivantes : 10 nm à 10 $\mu$m.

Les creux et/ou reliefs peuvent également prendre la forme d'une grille ou grillage.

La structure magnétique à miroir magnétique, selon l'invention, est telle que le champ magnétique est maximum ($B_{max}$) à l'injection micro-ondes, puis le champ magnétique est minimum ($B_{min}$) au centre de la chambre de dépôt, et enfin le champ magnétique remonte sur le substrat ($B_{substrat}$).

De préférence, le miroir magnétique est déséquilibré.

En d'autres termes, on est en présence d'un miroir magnétique important, en amont, à l'injection et plus faible en aval, c'est-à-dire au niveau du substrat.

Avantageusement, selon l'invention, le rapport miroir en amont, à l'injection micro-ondes, défini par $r_1 = B_{max}/B_{min}$ est supérieur ou égal à 4, par exemple égal à environ 4.

En effet, par exemple, pour une onde à 2,45 GHz, RCE = 875 G, $B_{max} \simeq 2\,000$ G et $B_{min} \simeq 500$ G, d'où un rapport $r_1 = 4$.

Un tel rapport miroir élevé permet de faire diffuser les particules ionisées (ions et électrons) vers le substrat qui est à environ 700 G, sous l'effet d'un gradient descendant ou vers la fenêtre si celle-ci est à fort champ (2 000 G).

Avantageusement, le rapport miroir, en aval, vers le substrat, défini par $r_2 = B_{substrat}/B_{min}$ est supérieur ou égal à 1,5, par exemple égal à environ 1,5.

De préférence, selon l'invention, le substrat est chauffé à une température de 500°C à 750°C, de préférence de 550 à 700°C, pour fournir l'énergie d'activation nécessaire à la croissance.

On notera que cette température est relativement basse par rapport aux procédés de l'art antérieur, il en résulte que dans le procédé de l'invention, on peut utiliser, pour supporter les nanotubes, des substrats sensibles aux températures élevées qui ne pouvaient être utilisés dans l'art antérieur.

Le chauffage du substrat peut être réalisé par bombardement électronique et/ou par chauffage externe, les électrons sont ceux du plasma, attirés par le substrat.

Le substrat peut être choisi parmi une grande variété de matériaux, dont la température de déformation est supérieure à la température de fonctionnement, comme, par exemple, le verre ou le silicium.

Le substrat n'a pas besoin d'être conducteur. De toute façon, ce sont les nanotubes de carbone qui s'établiront au potentiel appliqué.

Selon l'invention, la pression est maintenue, généralement, inférieure ou égale à $10^{-3}$ mbar, par exemple, elle pourra être de $2.10^{-4}$ mbar, pour augmenter l'énergie des électrons et diminuer les recombinaisons. De préférence, la pression est inférieur ou égale à $10^{-4}$ mbar, de préférence encore égale à $10^{-4}$ mbar.

Des pressions inférieures ou égales à $10^{-5}$ mbar peuvent convenir, mais il est alors possible que la densité d'ions devienne faible.

Le gaz contenant du carbone peut contenir du carbone sous quelque forme que ce soit : toute molécule organique est acceptable.

Selon l'invention, le gaz contenant du carbone est généralement choisi parmi les alcanes, alcènes et alcynes, tels que, par exemple, le méthane, l'éthane, le propane, l'éthylène, l'acétylène et leurs mélanges, éventuellement additionnés d'hydrogène, en toute proportion.

Avantageusement, l'injection de la puissance micro-ondes a lieu à la fréquence de 2,45 GHz, qui est une fréquence industrielle peu coûteuse, et pour une valeur de champ magnétique B, correspondant à la RCE, de l'ordre de 875 Gauss. Cette valeur du champ magnétique est indépendante du gaz.

Le substrat peut être polarisé positivement, par exemple, à de +20 volts à +100 volts, avec un flux d'électrons qui favorise la croissance sans catalyseur, conformément à l'invention, le plasma étant mis à la masse.

Une autre possibilité consiste à polariser, le plasma négativement, par exemple, à de -20 volts et -100 volts, le substrat étant mis à la masse.

L'invention a également trait à un dispositif de dépôt par plasma à la résonance cyclotron électronique de couches de tissus de nanofibres de carbone sur un substrat exempt de catalyseur, ledit dispositif comprenant :

- une chambre de dépôt ;
- des moyens pour créer une structure magnétique à miroir magnétique, de préférence déséquilibré, dans ladite chambre de dépôt ;
- une zone de résonance cyclotron électronique à l'intérieur même ou en bordure de ladite chambre de dépôt et faisant face audit substrat ;
- des moyens d'injection d'une puissance micro-ondes dans ladite chambre de dépôt ;
- des moyens pour créer une pression inférieure à $10^{-3}$ mbar d'un gaz contenant du carbone à l'intérieur de ladite chambre de dépôt ; la surface dudit substrat présentant des reliefs et/ou des creux. De préférence, les reliefs et/ou les creux comportent au moins une surface sensiblement perpendiculaire au plan principal de la surface du substrat. C'est préférable pour que les tubes « décollent » de la surface, sinon il y a une croissance de type lierre.

Le dispositif selon l'invention peut comprendre, en outre, des moyens de chauffage du substrat, si le substrat n'est pas suffisamment chauffé par les électrons du plasma qui bombardent le substrat.

Le dispositif selon l'invention peut aussi comprendre, en outre, des moyens de création d'une différence de potentiel entre le plasma et le substrat.

Comme on l'a déjà indiqué, le dispositif selon l'invention se distingue des dispositifs de l'art antérieur à plasma RCE, essentiellement par le fait qu'il n'y a pas de séparation entre la chambre de création du plasma, la diffusion, et la chambre de dépôt, puisque la zone de RCE est de préférence intégrée à la chambre de dépôt ou en bordure de celle-ci.

Le dispositif selon l'invention permet la croissance de nanotubes monoparois, sans catalyseur et à faible température, à savoir de 500°C à 700°C avec notamment du méthane.

L'invention concerne, en outre, un substrat dont la surface présente des reliefs et/ou des creux, ledit substrat comportant des nanotubes de carbone monoparoi exempts de catalyseur.

De préférence, les reliefs et/ou les creux comportent au moins une surface sensiblement perpendiculaire au plan principal de la surface du substrat et les nanotubes sont alors, de préférence, sensiblement perpendiculaires au plan principal de la surface du substrat.

Ou bien les reliefs et/ou les creux peuvent avoir une forme courbe, curviligne, respectivement concave ou convexe.

Les nanotubes de carbone monoparois, selon l'invention, sont d'excellente qualité sur toute leur longueur et ne sont pas, de préférence, enchevêtrés du fait de leur position, qui est, de préférence, sensiblement perpendiculaire au substrat.

Ils peuvent toutefois être regroupés sous la forme de faisceaux ou de fagots.

Une telle couche de nanotubes de carbone monoparois, de préférence sensiblement perpendiculaire à la surface d'un substrat, n'a jamais pu être obtenue par des procédés de l'art antérieur et peut être préparée pour la première fois par le procédé de l'invention sans catalyseur, du fait de la mise en oeuvre d'une source de plasma RCE particulière, confinente, de la basse pression utilisé, et du substrat particulier.

Les nanotubes, selon l'invention, sont de préférence parfaitement ordonnés, orientés, non enchevêtrés, au contraire de l'art antérieur où ils sont disposés de manière aléatoire désordonnée, et où ils sont, en outre, pollués, contaminés par du catalyseur en quantités souvent importantes et/ou contaminés par des particules de carbone amorphe ou de suie.

Par « exempts de catalyseur », on entend que les nanotubes selon l'invention ne comprennent pas d'éléments pouvant être définis comme des catalyseurs, ces éléments étant essentiellement des métaux de transition, comme le nickel, le cobalt, le fer, et que ces éléments sont présents à l'état de trace ou d'impuretés habituelles.

Par nanotubes, on entend généralement que le diamètre du tube monoparoi sans catalyseur de l'invention est de 0,7 à 2 ou 3 nm et jusqu'à quelques nm.

La longueur des nanotubes monoparois selon l'invention est généralement un ou quelques nm à un ou quelque $\mu$m, par exemple, de 1 nm à 10 $\mu$m.

Les nanotubes selon l'invention, outre leur structure spécifique possèdent un certain nombre de propriétés excellentes, qui les rendent particulièrement adéquats à un grand nombre d'applications.

Les nanotubes de carbone selon l'invention sont conducteurs électriques ou semi-conducteurs et réfractaires.

Ils possèdent une tenue en température qui est généralement supérieure à 700°C.

Les nanotubes sont émetteurs d'électrons par effet de champ, à un champ seuil de quelques V/$\mu$m, typiquement 1 - 2 V/pm, ces seuils sont les seuils les plus bas qui existent.

De plus, les nanotubes sont inertes chimiquement à la température ambiante.

Enfin, on peut réaliser pour la première fois, selon l'invention, des substrats pourvus de nanotubes sur une grande surface, par exemple, de 0,25 $m^2$ à 1 $m^2$ et sans catalyseur.

Les propriétés décrites ci-dessus sont mises à profit dans les nombreuses applications possibles des nanotubes monoparois, à savoir les nanoconducteurs, les nano-semi-conducteurs, les pointes AFM, le stockage d'hydrogène, l'émission d'électrons, le greffage de molécules, qu'elles soient biologiques ou non biologiques, à l'instar de, ce qui a été décrit dans le document [1].

Trois des applications principales de l'invention sont fonctions de la nature des reliefs :

- lorsque le relief présente une surface perpendiculaire au substrat, cela peut servir à faire des nanopointes utilisées dans les écrans plats ;
- si le relief est courbe, il peut être utilisé pour faire passer le courant entre deux électrodes, par exemple pour des mémoires nanoélectriques de nanoconducteurs ;
- si le relief est quelconque, il peut être utilisé pour stocker l'hydrogène sur les tubes de carbone dans une application du type pile à combustible (faisceau de tubes).

Brève description des dessins

- La figure 1A représente un nanotube de carbone multiparoi ;
- la figure 1B illustre un nanotube de carbone monoparoi ;
- la figure 1C représente un faisceau ou fagot de nanotubes de carbone monoparoi ;
- la figure 2 est une vue en coupe schématique d'un dispositif à source à plasma à résonance cyclotron électronique pour la mise en oeuvre du procédé selon l'invention ;
- la figure 3 représente le début de la croissance de faisceaux de nanotubes de carbone monoparoi sur un substrat profilé formé d'une plaque plane munie de rayures, d'arêtes et de gorges, cannelures, à section rectangulaire ;
- la figure 4 représente le début de la croissance de faisceaux de nanotubes de carbone monoparoi sur un substrat profilé formé d'une plaque plane munie de microplots ;
- la figure 5 est une image au microscope électronique en transmission de nanotubes de carbone monoparoi obtenus par un procédé de l'art antérieur à l'arc électrique avec un catalyseur Rh-Pt. Une graduation représente 20 nm ;
- la figure 6 est une image au microscope électronique en transmission de nanotubes de carbone monoparoi obtenus par le procédé selon l'invention sans catalyseur avec un plasma RCE de méthane. Une graduation représente 10 nm ;
- la figure 7 est une image tangente au substrat, prise au microscope électronique en transmission à plus faible grossissement que l'image de la figure 6 qui illustre la croissance de faisceaux de nanotubes de carbone monoparois par le procédé selon l'invention, sans catalyseur, avec un plasma RCE à partir d'un substrat de tungstène comportant des rayures.

Une graduation représente 200 nm.

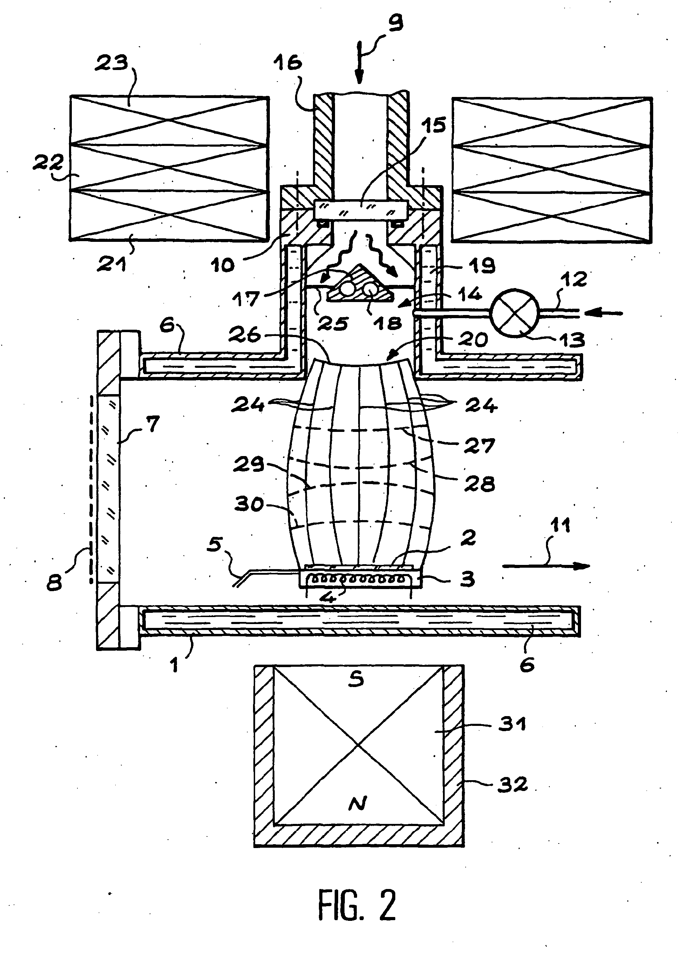

De manière plus détaillée, le procédé selon l'invention peut être mis en oeuvre, par exemple, avec le dispositif, tel que celui qui est décrit sur la figure 2.

Ce dispositif comprend essentiellement une chambre de dépôt (1), dans lequel on trouve un substrat (2).

Ce substrat peut être fixe ou animé, par exemple, d'un déplacement rectiligne de translation, le substrat peut être polarisé, positivement, ou mis à la masse.

De préférence, le substrat est polarisé positivement, généralement à de +10 à +100 volts, une telle polarisation positive permet de compléter la dissociation des molécules organiques sur le substrat.

Le substrat a généralement une forme plane et une taille de 0,25 m$^2$ à 1 m$^2$, c'est là, on l'a vu, un des avantages de l'invention que de permettre le dépôt de nanotubes de carbone sur des surfaces relativement grandes, par exemple, de la taille du substrat de 0,25 à 1 m$^2$, et plus, ce qui est particulièrement intéressant pour les écrans plats, et les plaquettes en microélectronique.

Le substrat est, par exemple, en verre, comme un verre de type borosilicate, en silicium, tantale ou molybdène.

Selon un mode de réalisation particulièrement intéressant, le substrat comporte du tunsgtène.

Le substrat peut être choisi parmi les substrats en tungstène massif, les substrats constitués d'une couche, de préférence fine, de tungstène, déposée par exemple sur du silicium, du verre, et les substrats constitués d'un grille de tungstène.

Ce mode de réalisation est particulièrement intéressant car avec un tel substrat, le rendement de croissance des nanotubes est élevé, ils croissent plus haut et plus vite.

Selon une caractéristique essentielle de l'invention, la surface du substrat est pourvue de creux et/ou de reliefs, autrement dit elle est profilée ou non-lisse.

Les creux et/ou reliefs peuvent avoir une forme quelconque.

Avantageusement, cependant, ces creux, reliefs ou profils, comportent au moins une surface sensiblement perpendiculaire au plan principal de la surface du substrat.

Les creux et/ou reliefs peuvent avoir aussi une forme courbe, curviligne, respectivement concave ou convexe.

Le substrat peut donc se présenter, de préférence sous la forme d'une plaque plane, et est pourvu de tranchées, rainures, rayures, cannelures, gorges (avec les arêtes correspondantes), trous, cavités, plots, pointes, aspérités, bossages ou gaufrages présentant, de préférence au moins une surface sensiblement perpendiculaire au plan du substrat ou bien courbes, curvilignes.

Du fait que ces motifs ont généralement une taille de quelques micromètres ou fractions de micromètres, on utilisera les termes de microtranchées, microrainures, microtrous, etc..

Ainsi, le substrat pourra être constitué d'une plaque plane munie d'arêtes parallèles de section rectangulaire d'une hauteur, par exemple de 10 nm à 1 $\mu$m, selon l'utilisation, et d'une largeur de 10 nm à 10 $\mu$m (la hauteur étant perpendiculaire au plan du substrat), chaque arête étant séparée par une gorge gouttière, ou rainure, de même section rectangulaire, de profondeur égale à la hauteur déjà indiquée et dont la largeur est de 10 nm à quelques $\mu$m (Figure 3).

Le substrat pourra aussi être constitué d'une plaque plane pourvue de plots de forme parallélépipédique d'une largeur de quelques nm à quelques $\mu$m, d'une longueur de quelques nm à quelques $\mu$m et d'une hauteur de quelques nm à quelques $\mu$m (Figure 4) (la hauteur étant perpendiculaire à la surface du substrat).

Ces plots sont généralement répartis selon un motif régulier, par exemple, un motif en carrés sur la surface du substrat.

De telles conformations du substrat permettent, dès le début de la croissance, d'obtenir des nanotubes de carbone orientés essentiellement perpendiculairement à la surface du substrat, comme cela ressort des figures 3 et 4.

La surface du substrat pourra également comporter des pointes, par exemple métalliques, ou semi-conductrices réparties de manière régulière ou irrégulière sur la surface du substrat ; ces pointes étant de préférence sensiblement perpendiculaires du plan principal de la surface du substrat.

Sur la figure 2, sont prévus des moyens de chauffage du substrat sous la forme d'un porte-substrat chauffant (3) muni, par exemple, d'une résistance chauffante (4). En outre, il est prévu un thermocouple (5) pour mesurer la température du substrat pendant le procédé. La température du substrat est généralement de 500 à 750°C.

La chambre ou enceinte de dépôt a sur la figure 2 une forme sensiblement parallélépipédique pour les applications « grande surface » et « magnétisation », et horizontale, les parois sont munies de moyens de refroidissement sous la forme d'un chemisage ou double paroi (6), dans lequel circule un fluide de refroidissement, qui est, de préférence, de l'eau.

Sur la figure 2, est prévu, dans l'une des bases du parallélépipède formant la chambre de dépôt, un hublot d'observation (7) équipé, en outre, d'un grillage de protection (8) pour les micro-ondes.

La chambre ou enceinte de dépôt (1) reçoit la puissance générée par un ou plusieurs émetteurs micro-ondes (flèche 9), par l'intermédiaire d'un coupleur (10) qui répartit cette puissance dans la chambre ou enceinte de dépôt. La puissance micro-ondes est généralement de 600 à 800 Watts, avec une fréquence, par exemple, de 2,45 GHz.

Cette injection de puissance micro-ondes dans l'enceinte produit l'ionisation d'un gaz sous faible pression contenant du carbone.

Selon l'invention, cette pression est une faible pression, à savoir, comme on l'a déjà indiqué plus haut, une pression inférieure à $10^{-3}$ mbar, par exemple $2.10^{-4}$ mbar.

La faible pression à l'intérieur de l'enceinte ou chambre de dépôt est maintenue par l'intermédiaire d'un pompage, représenté par la flèche (11).

Le gaz contenant du carbone est, quant à lui, introduit, injecté, en amont, dans le coupleur, par exemple par une canalisation (12) munie d'une vanne de régulation et de fuite (13).

Le gaz est choisi, par exemple, parmi le méthane, l'éthane, l'éthylène, l'acétylène et leurs mélanges, éventuellement additionné d'hydrogène, le méthane est préféré.

Le coupleur (10) comprend un guide d'injection micro-ondes se terminant par une partie de section plus importante (14) qui est connectée à la chambre ou enceinte de dépôt perpendiculairement à celle-ci. Il est à noter, ce qui n'est pas le cas sur la figure 2, que ce guide d'injection peut former un coude faisant un angle de 90° pour protéger la fenêtre micro-onde.

Une fenêtre d'étanchéité aux micro-ondes (15), par exemple, en quartz, est disposée dans le guide d'onde entre le guide d'onde d'admission (16) et ladite partie de section plus importante (14) (ou le coude à 90°).

Cette fenêtre d'étanchéité (15) assure la séparation entre le guide d'admission, ou d'injection (16) dans laquelle se trouve de l'air à la pression atmosphérique et la partie de section plus importante (14), ainsi que l'enceinte ou chambre de dépôt (1) qui sont sous vide, grâce au pompage (11).

En aval de la fenêtre micro-ondes, dans la partie de section plus importante (14), est prévu un dispositif de protection (17) de la fenêtre micro-ondes qui se présente sous la forme, par exemple d'une pièce en forme de prisme vertical qui laisse passer les micro-ondes, mais qui protège la fenêtre d'un dépôt de carbone.

Ce dispositif est muni, en outre, de moyens de refroidissement (18) sous la forme de canalisations dans lesquelles circule un fluide de refroidissement, tel que de l'eau.

La partie de section plus importante du coupleur est également munie de moyens de refroidissement, à l'instar de la chambre de dépôt, sous la forme d'un chemisage ou double paroi (19), éventuellement connecté à celui de la chambre de dépôt et dans lequel circule un fluide de refroidissement, tel que de l'eau.

Dans une configuration non décrite sur la figure 2, l'injection micro-ondes (9) et la fenêtre d'étanchéité (15) sont situées à 90° de l'axe du dispositif, ce qui permet d'éviter que la fenêtre d'étanchéité ne soit recouverte par du carbone et assure un fonctionnement continu du dispositif.

Avantageusement, selon l'invention, la zone de résonance cyclotron électronique, représentée par la référence (20) figure 1, se trouve à l'intérieur même de la chambre ou enceinte de dépôt (1) et fait face au substrat (12).

Mais, la RCE peut être aussi située au bout du coupleur ou légèrement à l'intérieur de la chambre de dépôt.

De ce fait, il n'y a pas, de préférence, dans le dispositif de l'invention, dé séparation entre la chambre de création du plasma (RCE), la diffusion et la chambre de dépôt, puisque, selon l'invention, la zone de RCE est intégrée à la chambre de dépôt.

Selon l'invention, la puissance micro-ondes est injectée dans une structure magnétique spécifique à miroir magnétique.

Ce miroir magnétique est, de préférence, déséquilibré et comprend la zone de résonance cyclotron électronique (RCE) (20). Cette zone de RCE est positionnée comme indiqué ci-dessus, de préférence, à l'intérieur même de la chambre de dépôt (1), mais elle peut être aussi comme sur la figure 1, en bordure de la chambre de dépôt, ce qui provoque une dissociation et/ou une ionisation des molécules composant le gaz contenant du carbone, en produisant des espèces qui vont se déposer sur ledit substrat (2).

Le champ magnétique de résonance cyclotron électronique (RCE) peut être produit par des enroulements de conducteurs, tels que bobines ou solénoïdes de géométrie rectangulaire, carrée ou cylindrique ou par des aimants permanents.

Sur la figure 2, les bobines de champ magnétique sont des bobines de champ magnétique rectangulaires qui sont groupées par paquet de trois (21, 22, 23), de part et d'autre du coupleur, c'est-à-dire que le coupleur est à l'intérieur des trois bobines rectangulaires.

Les dimensions du dépôt dépendent principalement de la surface du champ magnétique de résonance cyclotron électronique (RCE) créé, et des lignes de champ de diffusion vers l'aimant (31). Le plasma suit les lignes jusqu'au substrat.

Le système magnétique (21, 22, 23) et l'aimant de reprise de flux (31) sont dans une configuration en addition de champ, c'est-à-dire que les champs générés par (21, 22, 23) et (31) sont dans le même sens dans la chambre de plasma.

Dans le cas des bobines de champ magnétique rectangulaires (21, 22, 23), illustrées sur la figure 2, on peut, par exemple, obtenir une hauteur de plasma de 25 cm, qui peut être étendue à 1 mètre. Dans ce dernier cas (hauteur de plasma, 1 m), on remplacera alors les bobines (21, 22, 23) par des aimants permanents, notamment pour limiter la consommation électrique.

Selon l'invention, le champ magnétique créé présente un profil particulier, formant de préférence une structure magnétique à miroir magnétique déséquilibré. De manière générale, les conditions suivantes doivent être remplies :

- un miroir avec un champ B minimum, par exemple de 500 à 600 G ;
- un fort champ à l'injection, à savoir à la fenêtre micro-ondes voisin, par exemple, de 2 000 G ; et
- un champ moyen sur le substrat, par exemple de 700 à 1 000 G si le champ $B_{min}$ est lui-même de 500 à 600 G.

En effet, selon l'invention, c'est le profil du champ qui est important. Pour cela, on alimente les bobines avec des courants pour obtenir les champs adéquats. Par exemple, les bobines (21), (22) et (23) sont alimentées avec 500 A - cette intensité dépendant du nombre de spires des bobines - ce qui donne un champ $B_{max}$ de 2 000 G au niveau de ces bobines, un $B_{min}$ de 500 G et un champ sur le substrat $B_{substrat}$ de 750 G.

Dans ce cas, les rapports désirés donnés ci-dessus, à savoir $r_1 \geq 4$, de préférence $r_1 \simeq 4$, et $r_2 \geq 1,5$, de préférence $r_2 \simeq 1,5$ sont bien vérifiés. En effet,

$$r_1 = \frac{2\ 000}{500} = 4 \ ; \ \text{et}$$

$$r_2 = \frac{700}{500} = 1,5 \ .$$

Sur la figure 2, outre les lignes représentant le champ magnétique axial (courbes 24, en trait continu), on a indiqué les lignes équimodules de champ magnétique (courbes ou lignes 25, 26, 27, 28, 29, 30, en pointillés).

On constate que le champ magnétique est maximum et élevé à l'injection micro-ondes, où il a une valeur, par exemple, de 2 000 G (25), puis il décroît à la zone de résonance cyclotron électronique (courbe 26), où il a une valeur de 875 G, il descend ensuite à 500 G (27), et le champ magnétique présente un minimum, par exemple, de 500 G au centre de la chambre de dépôt (28, 29), puis le champ magnétique remonte, tout d'abord, pour atteindre 600 G (30) et remonte encore pour arriver sur le substrat à une valeur de 700 à 1 000, par exemple de 750 G ou 800 G.

On a donc un miroir magnétique, de préférence relativement important à l'injection - pour protéger la fenêtre micro-onde et pour réfléchir les ions et les électrodes vers $B_{min}$ - et plus faible en aval.

En d'autres termes, il doit y avoir un miroir, c'est-à-dire que $B_{substrat}$ doit être inférieure à $B_{min}$ (par exemple 750 G > 500 G), mais ce miroir ne doit cependant pas être trop fort, sinon les espèces ionisées n'arrivent pas jusqu'au subtrat.

Typiquement, le rapport miroir à l'injection $r_1$ est environ égal à 4.

Ainsi, de nouveau, dans le cas du dispositif de la figure 2, $r_1 = B_{max}/B_{min} = 2\ 000\ G/500\ G = 4$.

Ce rapport miroir $r_1$ élevé permet de faire diffuser les particules ionisées, ions et électrons, vers le substrat, sous l'effet d'un gradient descendant.

Typiquement, le rapport miroir $r_2$ en aval, vers le substrat, est environ de 1,5.

Ainsi, dans le cas du dispositif de la figure 1, $r_2 = B_{substrat}/B_{min} = 750\ G/500\ G = 1,5$.

Outre les bobines (21, 22, 23), la structure magnétique à miroir et confinement magnétique comprend sur la figure 2 un aimant permanent (31) placé dans un carter ou boîtier (32) situé hors de la chambre de dépôt (1), derrière le substrat (2), qui permet de confiner le plasma dans la zone de diffusion. Cet aimant permanent comporte des moyens mécaniques en translation permettant d'ajuster sa position suivant son axe.

L'aimant permanent peut être, par exemple, en FeNdB avec un champ rémanent Br, par exemple de 1,33 T.

Comme on l'a déjà indiqué plus haut, le confinement magnétique notable, selon l'invention, permet d'augmenter le temps de vie des ions et des électrons qui restent piégés dans le miroir magnétique au centre de la chambre de dépôt et le long des lignes de champ.

Les taux de dissociation et d'ionisation des molécules dans le plasma sont donc ainsi augmentés avec des collisions électroniques du type :

$$CH_4 + e \rightarrow CH_3{}^+ + H° + e + e$$

$$CH_4 + e \rightarrow CH_3° + H° + e$$

$$CH° + e \rightarrow C° + H° + e,$$

etc.

L'invention va maintenant être décrite, en référence à l'exemple suivant, donné à titre illustratif et non limitatif.

Exemple

On effectue, selon l'invention, sur différents substrats et sans catalyseur, le dépôt de nanotubes de carbone monoparoi (SWNTs).

Le dispositif mis en oeuvre est sensiblement analogue à celui de la figure 2.

Les conditions expérimentales pour la synthèse des nanotubes de carbone monoparois sont les suivantes :

- gaz utilisé : méthane ;
- pression de méthane : $2 \times 10^{-4}$ mbar ;
- puissance micro-onde : 600 - 800 Watts (f = 2.45 GHz) ;
- polarisation du substrat : + 70 volts ;
- courant d'électrons sur le substrat : 0,8 Ampère ;
- température : 560°C ;
- durée du dépôt : 35 et 60 mn (On a deux exemples différents : 35 minutes pour l'exemple 2b et 60 minutes pour l'exemple 5) ;
- champ magnétique : le champ magnétique a le profil indiqué sur la figure 2 avec un champ de 2 000 G à l'injection micro-ondes, de 875 G à la zone de RCE, de 500 G, du centre de la chambre de dépôt, et d'environ 800 G sur le substrat ;
- le substrat est un substrat en tungstène, cannelé, nervuré comme décrit sur la figure 3 qui présente des cannelures, rayures ou nervures de section rectangulaire, d'une profondeur h de 0,3 $\mu$m et d'une largeur 1 de 0,1 $\mu$m ;

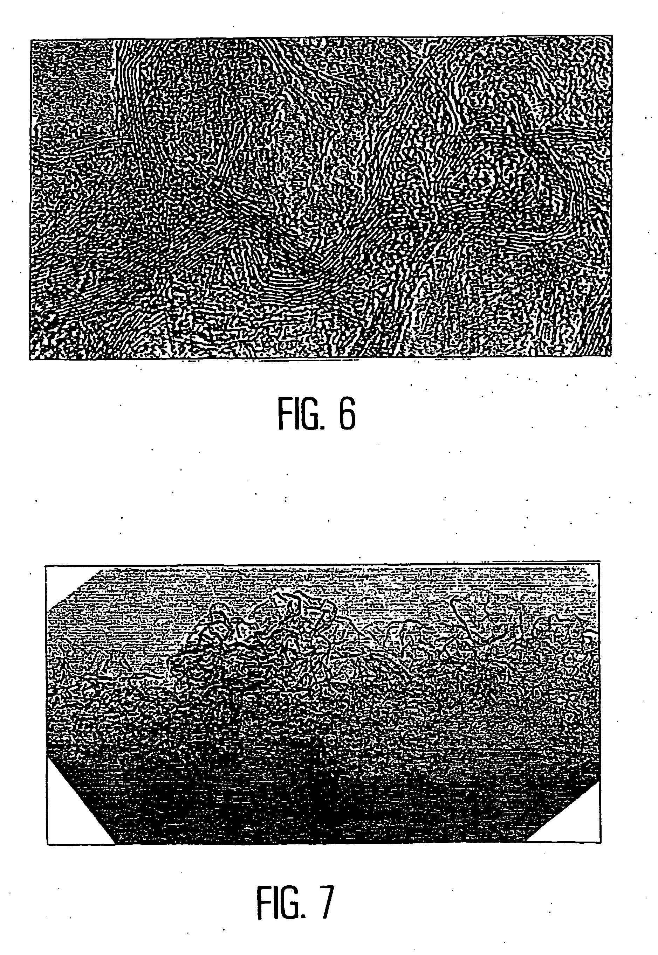

- les figures 6 et 7 sont des images au microscope électronique en transmission (MET) des nanotubes obtenus par le procédé de l'invention dans ces conditions.

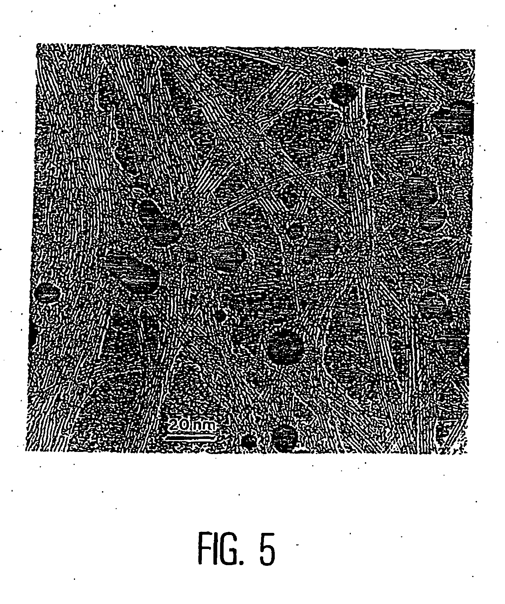

Les nanotubes qui ont cru perpendiculairement à la surface (voir aussi figure 4) du substrat sont groupés par faisceaux. Contrairement aux procédés de l'art antérieur, il n'apparaît pas d'îlots catalytiques, comme cela est illustré sur la figure 5, tirée du document de SAITO [5] et montrant des faisceaux de nanotubes de carbone obtenus par un procédé à l'arc électrique avec un catalyseur Rh - Pt.

Sur la figure 7, qui une vue au MET, des mêmes nanotubes que ceux de la figure 6 mais à plus faible grossissement et en prenant la vue de manière tangente au substrat, on met en évidence de manière très claire la croissance des faisceaux de SWNTs à partir du substrat sensiblement perpendiculairement à celui-ci.

Tableau I

| Méthodes de synthèse de nanotubes de carbone monoparois | | | | |
|---|---|---|---|---|
| Référence | Auteur | Dispositif | Catalyseur | Diamètre des nanotubes (nm) |
| [4] | BERNIER,... | Arc (graphite) | Ni - Co Co - Y | - 1,4 nm |
| [5] | SAITO,... | Arc (graphite) | Rh - Pt (non magnétique) | 0,7 - 1,3 - 1,8 nm |
| [2] | LIU | Arc + $H_2$ (graphite) | Ni, Co, Fe | ~ 1,8 nm |
| [6] | THESS,... | Ablation laser | Ni, Co | ~ 1,4 nm |
| [7] | CASSELL,... | Four $CH_4$ CVD 900°C | $Al_2O_3$/Fe/Mo | 0,7 nm à 1,7 nm |
| [8] | NIKOLAEV,... | Four Co + Fe$(CO)_5$ 800°C 1 200°C | Fe | ~ 0,7 nm |
| [1] | KONG,- | Four $CH_4$ CVD 1 000°C | Fe | 1 à 3 nm |

REFERENCES

[1] J. KONG et al., Nature, vol. 395, Oct. 1998, p. 78.

(2) C. LIU et al., Science, 286, (5442), 1 127.

[3] K. A. DEAN et al., Appl. Phys. Letter, vol. 75, no. 19, 8 Nov. 1999.

[4] C. JOURNET et al., Nature, vol. 388, Août 1997, p. 756.

[5] Y. SAITO et al., Chemical Physics Letters, 294, (1998), 593 - 598.

[6] A. THESS et al., Science, vol. 273, 26 juillet 1996, p. 483.

[7] A. M. CASSELL et al., J. Phys. Chem. B, 1999, 103, 6 484 - 6 492.

[8] P. NIKOLAEV et al., Chemical Physics Letters, 313, (1999), 91 - 97.

[9] M. DELAUNAY et al., Rev. of Sc. Instrum., vol. 69, N 6, Juin 1998, p. 2 320.

[10] M. DELAUNAY et al., Brevet EP 99 400164.2/ FR 98 00777.

[11] M. DELAUNAY et al., Brevet EP 99 401545.1/ FR 98 07993.

**Revendications**

1. Procédé de dépôt par plasma à la résonance cyclotron électronique de nanotubes de carbone monoparois, sur un substrat exempt de catalyseur, par injection d'une puissance micro-ondes dans une chambre de dépôt comprenant une structure magnétique de confinement à miroir magnétique, et au moins une zone de résonance cyclotron électronique à l'intérieur même ou en bordure de ladite chambre de dépôt et faisant face audit substrat, moyennant quoi, on provoque, sous une pression inférieure à $10^{-3}$ mbar, la dissociation et/ou l'ionisation d'un gaz contenant du carbone dans ledit miroir magnétique au centre de la chambre de dépôt, en produisant des espèces qui vont se déposer sur ledit substrat qui est chauffé ; procédé dans lequel la surface du substrat présente des reliefs et/ou des creux, et lesdits reliefs et/ou lesdits creux comportent au moins une surface sensiblement perpendiculaire au plan principal de la surface du substrat.

2. Procédé de dépôt selon la revendication 1, comprenant les étapes suivantes :

   - chauffage du substrat ;
   - établissement d'une pression inférieure ou égale à $10^{-3}$ mbar, de gaz contenant du carbone ;
   - injection de la puissance micro-ondes, et création du plasma à partir dudit gaz contenant du carbone, pour une valeur du champ magnétique correspondant à la résonance cyclotron électronique ;
   - création d'une différence de potentiel entre le plasma et le substrat ;
   - dissociation et/ou ionisation des molécules dans ledit miroir magnétique au centre de la chambre de dépôt ;
   - dépôt des espèces formées sur ledit substrat pour obtenir des nanotubes de carbone monoparois.

3. Procédé selon l'une quelconque des revendications 1 à 2, dans lequel le miroir magnétique est déséquilibré.

4. Procédé selon l'une quelconque des revendications 1 à 3, dans lequel ladite structure du miroir magnétique est telle que le champ magnétique est maximum ($B_{max}$) à l'injection micro-ondes, puis le champ magnétique est minimum ($B_{min}$) au centre de la chambre de dépôt et enfin le champ magnétique remonte sur le substrat ($B_{substrat}$).

5. Procédé selon l'une quelconque des revendications 1 à 4, dans lequel le rapport miroir en amont à l'injection micro-ondes, défini par $r_1 = B_{max}$ (en Gauss)/$B_{min}$ (en Gauss) est supérieur (ou égal) à 4.

6. Procédé selon l'une quelconque des revendications 1 à 5, dans lequel le rapport miroir, en aval, vers le substrat, défini par $r_2 = B_{substrat}$ (en Gauss)/$B_{min}$ est supérieur ou égal à 1,5.

7. Procédé selon l'une quelconque des revendications 1 à 6, dans lequel le substrat est chauffé à une température de 500 à 750°C.

8. Procédé selon la revendication 1, dans lequel le chauffage du substrat est réalisé par bombardement électronique et/ou par chauffage externe.

9. Procédé selon la revendication 1, dans lequel le substrat est polarisé positivement, par exemple, à de +20 volts +100 volts, et le plasma est mis à la masse.

10. Procédé selon la revendication 1, dans lequel le plasma est polarisé négativement, par exemple, à de -20 volts à -100 volts et le substrat est mis à la masse.

11. Procédé selon l'une quelconque des revendications 1 à 10, dans lequel la surface du substrat présente des tranchées et/ou rainures, et/ou gorges, et/ou arêtes, et/ou cannelures, et/ou trous, et/ou cavités, et/ou plots, et/ou pointes, et/ou aspérites, et/ou bossage, et/ou gauffrages.

12. Substrat dont la surface présente des reliefs et/ou des creux, ledit substrat comportant des nanotubes de carbone monoparois exempts de catalyseur, et lesdits reliefs et/ou lesdits creux comportant au moins une surface sensiblement perpendiculaire au plan principal de la surface du substrat.

13. Substrat selon la revendication 12, dans lequel les nanotubes sont sensiblement perpendiculaires au plan principal de la surface du substrat.

14. Substrat selon la revendication 12, dans lequel le relief comprend des pointes, de préférence métalliques ou semi-conductrices.

15. Substrat selon la revendication 12, dans lequel le diamètre des monoparois est de 0,7 à 3 nm et leur longueur est de 10 nm à quelques $\mu$m.

16. Procédé ou substrat selon l'une quelconque des revendications 1 à 15, dans lequel le substrat comporte du tungstène.

17. Procédé ou substrat selon la revendication 16, dans lequel le substrat est choisi parmi les substrats en tungstène massif, les substrats constitués d'une couche de tungstène, déposée par exemple sur du silicium, du verre, et les substrats constitués d'un grillage de tungstène.

**Claims**

1. Electron cyclotron resonance plasma deposition process for single-wall carbon nanotubes on a catalyst-free substrate, by injection of a microwave power in a deposition chamber comprising a magnetic confinement structure with a magnetic mirror, and at least one electron cyclotron resonance area inside or at the border of said deposition chamber and facing said substrate, whereby dissociation and / or ionization of a gas containing carbon is caused, at a pressure of less than $10^{-3}$ mbars, in said magnetic mirror at the center of the deposition chamber, producing species that will be deposited on said heated substrate; process in which the substrate surface includes raised and/or lowered reliefs, and said raised and/or lowered reliefs comprise at least one surface approximately perpendicular to the main plane of the substrate surface.

2. Deposition process according to claim 1, comprising the following steps:

   - heating the substrate;
   - creating a pressure of less than or equal to $10^{-3}$ mbars, of a gas containing carbon;
   - injection of the microwave power and creation of the plasma from said gas containing carbon, for a value of the magnetic field corresponding to electron cyclotron resonance;
   - creation of a potential difference between the plasma and the substrate;
   - dissociation and / or ionization of molecules in said magnetic mirror at the center of the deposition chamber;
   - deposition of the formed species on said substrate to obtain single-wall carbon nanotubes.

3. Process according to any one of claims 1 to 2, wherein the magnetic mirror is unbalanced.

4. Process according to any one of claims 1 to 3, wherein the magnetic mirror type magnetic structure is such that the magnetic field is maximum ($B_{max}$) at the microwave injection, and the magnetic field is then minimum ($B_{min}$) at the center of the deposition chamber, and finally the magnetic field raises again on the substrate ($B_{substrate}$).

5. Process according to any one of claims 1 to 4, wherein the "upstream" mirror ratio at the microwave injection, as

defined by $r_1 = B_{max}$ (in Gauss)/$B_{min}$ (in Gauss), is greater than (or equal to) 4.

6. Process according to any one of claims 1 to 5, wherein the "downstream" mirror ratio, towards the substrate, defined as $r_2 = B_{substrate}$ (in Gauss)/$B_{min}$ (in Gauss), is greater than or equal to 1.5.

7. Process according to any one of claims 1 to 6, wherein the substrate is heated to a temperature of 500°C to 750°C.

8. Process according to claim 1, wherein the substrate is heated by electronic bombardment and / or external heating.

9. Process according to claim 1, wherein the substrate is positively polarized, for example at between +20 volts and +100 volts, and the plasma is grounded.

10. Process according to claim 1, wherein the plasma is negatively polarized, for example at between - 20 volts and -100 volts, and the substrate is grounded.

11. Process according to any one of claims 1 to 10, wherein the surface of the substrate includes, trenches and / or slots, and / or grooves and / or ridges and / or corrugations and / or holes and / or cavities, and / or pads and / or spikes and / or projections and / or boss and / or embossments.

12. Substrate, which surface has raised and / or lowered reliefs, said substrate comprising catalyst-free single-wall carbon nanotubes, and said raised and / or lowered reliefs comprise at least one surface approximately perpendicular to the main plane of the surface of the substrate.

13. Substrate according to claim 12, in which the nanotubes are approximately perpendicular to the main plane of the surface of the substrate.

14. Substrate according to claim 12, in which the surface of the relief comprises spikes, preferably metallic spikes, or semiconducting spikes.

15. Substrate according to claim 12, wherein the diameter of the single walls is of from 0.7 to 3 nm, and their length is of from 10 nm to a few $\mu$m.

16. Process or substrate according to any one of claims 1 to 15, wherein the substrate comprises tungsten.

17. Process or substrate according to claim 16, wherein the substrate is chosen from among solid tungsten substrates, substrates consisting in a thin layer of tungsten, for example deposited on silicon or glass, and substrates consisting in a tungsten grid.

**Patentansprüche**

1. Verfahren zum Elektron-Zyklotron-Resonanz Plasma Aufbringen von einwandigen Kohlenstoffnanoröhren auf einem katalysatorfreien Substrat, durch Injektion einer Mikrowellenleistung in eine Abscheidungskammer umfassend eine magnetische Begrenzungsstruktur mit einem magnetischen Spiegel und wenigstens eine Elektron-Zyklotron-Resonanz-Zone innerhalb oder an der Grenze der Abscheidungskammer und dem Substrat gegenüberliegend, wobei unter einem Druck von weniger als $10^{-3}$ mbar die Dissoziation und/oder Ionisation eines kohlenstoffhaltigen Gases in dem magnetischen Spiegel im Mittelpunkt der Abscheidungskammer bewirkt wird, wobei Arten erzeugt werden, die auf dem Substrat, welches erwärmt ist, abgeschieden werden; wobei die Oberfläche des Substrates bei dem Verfahren Reliefs bzw. Erhebungen und/oder Vertiefungen aufweist, und wobei die Erhebungen und/oder Vertiefungen wenigstens eine Oberfläche umfassen, die in etwa senkrecht zu der Hauptebene der Substratoberfläche ist.

2. Verfahren zur Abscheidung nach Anspruch 1, umfassend die folgenden Schritte:

   - Erwärmen des Substrates;
   - Herstellen eines Drucks von weniger als $10^{-3}$ mbar oder von $10^{-3}$ mbar aus kohlenstoffhaltigem Gas;
   - Injektion der Mikrowellenleistung und Erzeugung des Plasmas aus dem kohlenstoffhaltigen Gas, für einen Wert des magnetischen Feldes entsprechend der Elektron-Zyklotron-Resonanz;
   - Erzeugen eines Potentialunterschiedes zwischen dem Plasma und dem Substrat;

- Dissoziation und/oder Ionisation der Moleküle in dem magnetischen Spiegel im Mittelpunkt der Abscheidungskammer;
- Abscheidung der gebildeten Arten auf das Substrat, um einwandige Kohlenstoffnanoröhren zu erhalten.

**3.** Verfahren nach einem der Ansprüche 1 bis 3, wobei der magnetische Spiegel unausgeglichen ist.

**4.** Verfahren nach einem der Ansprüche 1 bis 3, wobei die Struktur des magnetischen Spiegels so ist, dass das magnetische Feld bei der Injektion der Mikrowellen maximal ($B_{max}$) ist, und das Magnetfeld dann im Mittelpunkt der Abscheidungskammer minimal ($B_{min}$) ist und sich das magnetische Feld schließlich wieder auf dem Substrat ($B_{substrat}$) erhöht.

**5.** Verfahren nach einem der Ansprüche 1 bis 4, wobei das Verhältnis des Spiegels, flussauf, an der Injektion der Mikrowellen, definiert durch $r_1 = B_{max}$ (in Gauss) / $B_{min}$ (in Gauss) , 4 beträgt oder größer als 4 ist.

**6.** Verfahren nach einem der Ansprüche 1 bis 5, wobei das Verhältnis des Spiegels, flussab, zu dem Substrat, definiert durch $R_2 = B_{Substrat}$ (in Gauss) / $B_{min}$ , 1,5 beträgt oder größer als 1,5 ist.

**7.** Verfahren nach einem der Ansprüche 1 bis 6, wobei das Substrat auf eine Temperatur von 500°C bis 750°C erwärmt wird.

**8.** Verfahren nach Anspruch 1, wobei das Substrat durch Elektronenbeschuß und/oder externe Erwärmung erwärmt wird.

**9.** Verfahren nach Anspruch 1, wobei das Substrat positiv polarisiert ist, z.B. bei zwischen +20 Volt und +100 Volt, und das Plasma geerdet ist.

**10.** Verfahren nach Anspruch 1, wobei das Plasma negativ polarisiert ist, z.B. auf -20 Volt bis -100 Volt, und das Substrat geerdet ist.

**11.** Verfahren nach einem der Ansprüche 1 bis 10, wobei die Oberfläche des Substrats Gräben und/oder Einkerbungen bzw. Nuten, und/oder Rillen, und/oder Erhebungen bzw. Grate, und/oder Rinnen, und/oder Löcher, und/oder Hohlräume, und/oder Stufen, und/oder Spitzen, und/oder Vorsprünge, und/oder Buckel, und/oder Prägungen aufweist.

**12.** Substrat, auf dessen Oberfläche Reliefe bzw. Erhebungen und/oder Vertiefungen vorhanden sind, wobei das Substrat katalysatorfreie einwandige Kohlenstoffnanoröhren umfasst, wobei die Erhebungen und/oder Vertiefungen wenigstens eine Oberfläche umfassen, welche in etwa senkrecht zu der Hauptebene der Oberfläche des Substrates ist.

**13.** Substrat nach Anspruch 12, wobei die Nanoröhren im wesentlichen senkrecht zu der Hauptebene der Oberfläche des Substrates sind.

**14.** Substrat nach Anspruch 12, wobei das Relief bzw. die Erhebungen Spitzen, welche vorzugsweise metallisch oder halbleitend sind, umfasst.

**15.** Substrat nach Anspruch 12, wobei der Durchmesser der einzelnen bzw. einen Wand 0,7 bis 3 nm und die Länge von 10 nm bis einige $\mu$m beträgt.

**16.** Verfahren oder Substrat nach einem der Ansprüche 1 bis 15, wobei das Substrat Wolfram aufweist.

**17.** Verfahren oder Substrat nach Anspruch 16, wobei das Substrat gewählt wird aus massiven Wolframsubstraten, Substraten, die eine Wolframschicht aufweisen, die z.B. auf Silizium oder Glas abgeschieden ist, und Substraten, die aus einem Wolframgitter bestehen.

FIG. 1 A

FIG. 1 B

FIG. 1 C

FIG. 2

FIG. 3

FIG. 4

FIG. 5

FIG. 6

FIG. 7

## RÉFÉRENCES CITÉES DANS LA DESCRIPTION

**Documents brevets cités dans la description**

- EP 99400164 A, M. DELAUNAY
- FR 9800777
- EP 99401545 A, M. DELAUNAY
- FR 9807993

**Littérature non-brevet citée dans la description**

- **J. KONG et al.** *Nature,* Octobre 1998, vol. 395, 78
- **C. LIU et al.** *Science,* vol. 286 (5442), 1 127
- **K. A. DEAN et al.** *Appl. Phys. Letter,* 08 Novembre 1999, vol. 75 (19
- **C. JOURNET et al.** *Nature,* Août 1997, vol. 388, 756
- **Y. SAITO et al.** *Chemical Physics Letters,* 1998, vol. 294, 593-598
- **A. THESS et al.** *Science,* 26 Juillet 1996, vol. 273, 483
- **A. M. CASSELL et al.** *J. Phys. Chem. B,* 1999, vol. 103 (6), 484-486492
- **P. NIKOLAEV et al.** *Chemical Physics Letters,* 1999, vol. 313, 91-97
- **M. DELAUNAY et al.** *Rev. of Sc. Instrum.,* Juin 1998, vol. 69 (6), 2 320